# EUROPEAN PATENT APPLICATION

(11) **EP 3 734 302 A1**
(43) Date of publication of application: **04.11.2020**
(21) Application number: 19172490.5
(22) Date of filing: 03.05.2019
(51) Int. Cl.: G01R 31/28

(54) **CRYOGENIC WAFER PROBER WITH CAMERA, WINDOW AND SHUTTER**

(71) Applicant: Afore Oy, 21420 Lieto (FI); BlueFors Cryogenics Oy, 00370 Helsinki (FI)
(72) Inventor: JUNES, Aki, 20100 Turku (FI); KUUKKALA, Ari, 20540 Turku (FI); SALMINEN, Timo, 20750 Turku (FI); HENTTONEN, Vesa, 20380 Turku (FI); MANNINEN, Matti, 02340 Espoo (FI); GUNNARSSON, David, 00370 Helsinki (FI); ROSCHIER, Leif, 01600 Vantaa (FI)
(74) Representative: Berggren Oy, Turku

(57) **Abstract**

The present invention provides a testing device (100) for electrically testing integrated circuits on a wafer (102). The testing device (100) comprises a vacuum chamber (109), a chuck (101) for holding the wafer (102), a probe card (103) for electrically contacting the integrated circuits, a radiation shield (107) arranged inside the vacuum chamber (109) and enclosing the chuck (101) and the probe card (103) and means (119, 120, 121, 122) for moving the chuck (101) relative to the probe card (103). The testing device (100) further comprises a vision system (116) that is positioned outside the vacuum chamber (109) and aligned in line with a window (111) in the vacuum chamber (109) and an opening with a shutter (115) in the radiation shield (107) to determine the position of the wafer (102) with respect to the probe card (103).

## Description

### TECHNICAL FIELD OF THE INVENTION

The present invention relates to a testing device according to the preamble of the appended independent claim.

### BACKGROUND OF THE INVENTION

Semiconductor device fabrication is a commonly used process for creating integrated circuits on a wafer made of a semiconductor material using multiple-step sequence of photolithographic and chemical processing steps. As a part of the process, the integrated circuits created on the wafer are typically tested for functional defects by applying special test patterns to them. This testing is performed by using a testing device called a wafer prober.

An example of a known wafer prober comprises a chuck for holding a wafer to be tested and a probe card for electrically contacting integrated circuits on the wafer. The probe card is electrically connected to an electronic testing unit that electrically tests the integrated circuits according to a test program. The test program defines the contents of test patterns and the sequence by which they are applied to the integrated circuits. The chuck and the probe card are arranged inside a chamber, which allows the integrated circuits to be tested in a controlled environment. For electrical testing, the probe card is held in place while the wafer mounted on the chuck is moved between testing positions. In each testing position, contact elements of the probe card are arranged in electrical contact with contact pads of a set of integrated circuits, which are then electrically tested with the electronic testing unit. A vision system arranged inside the chamber is used in determining and verifying the position of the wafer during the testing.

A problem associated with the known wafer prober is that testing of integrated circuits is difficult or even impossible at very low temperatures, especially below 4 K, because the vision system does not work properly at these temperatures. Another problem associated with the known wafer prober is the heat generated by the vision system.

### OBJECTIVES OF THE INVENTION

It is the main objective of the present invention to reduce or even eliminate the prior art problems presented above.

It is an objective of the present invention to provide a testing device for electrically testing integrated circuits on a wafer. In more detail, it is an objective of the invention to provide a testing device in which the position of a wafer with respect to a probe card can be determined with a minimal temperature rise inside the testing device. It is a further objective of the present invention to provide a testing device enabling to minimize the light exposure to the space in which the integrated circuits are tested. It is yet a further objective of the present invention to provide a testing device enabling to electrically test integrated circuits on a wafer at very low temperatures, and even below 4 K. It is yet a further objective of the present invention to provide a testing device enabling to maintain the testing temperature below 4 K using a minimum amount of energy.

In order to realise the above-mentioned objectives, the testing device according to the invention is characterised by what is presented in the characterising portion of the appended independent claim. Advantageous embodiments of the invention are described in the dependent claims.

### DESCRIPTION OF THE INVENTION

A testing device according to the invention comprises a vacuum chamber, a chuck for holding a wafer that comprises integrated circuits, a probe card for electrically contacting the integrated circuits on the wafer, a first radiation shield arranged inside the vacuum chamber and enclosing the chuck and the probe card, and means for moving the chuck relative to the probe card. In the testing device according to the invention the vacuum chamber comprises a first window, the first radiation shield comprises an opening provided with a shutter for closing the opening, and the testing device comprises a vision system positioned outside the vacuum chamber and aligned in line with the first window and the opening, the vision system being configured to determine the position of the wafer with respect to the probe card.

The testing device according to the invention can be used for electrically testing integrated circuits on a wafer. This testing device can be called as a wafer prober. The wafer to be tested is mounted on the chuck, which is moved between testing positions using the moving means. In each testing position, the probe card is in electrical contact with one or more integrated circuits, which can then be electrically tested. The position of the wafer with respect to the probe card is determined with the vision system. Using the position information, the wafer can be correctly positioned to the testing positions.

The chuck is used to hold the wafer during testing of the integrated circuits. The chuck can be, for example, a mechanical chuck that comprises a plurality of heat conducting pins for holding the wafer on a base plate of the chuck. Alternatively, the chuck can be, for example, an electrostatic chuck that comprises a metal base plate coated with a layer of dielectric material. By providing a voltage difference between the metal base plate and the wafer, an electrostatic force holds the wafer on the chuck. To maintain the flatness of the wafer and facilitate the rapid transfer of heat from the wafer, the chuck is preferably made of a heat conducting material, such as copper or gold. The chuck can be made of gold-plated copper. These materials provide good thermal properties and performance.

The probe card is used to electrically contact the integrated circuits on the wafer. The probe card may comprise a printed circuit board (PCB) and one or more contact elements, which can be arranged in electrical contact with contact pads of the integrated circuits. The probe card can be attached to a probe card holder that is attached to the first radiation shield. The probe card can be, for example, a needle, vertical pin, or MEMS (Micro Electro-Mechanical System) type probe card depending on the shape and form of the contact elements. The contact elements of the probe card can, for example, be made of tungsten or a tungsten/rhenium alloy. The contact pads of the integrated circuits can, for example, be made of aluminium, copper, copper alloys or many types of solders such as lead-tin and tin-silver. Typically, the probe card is custom-built for each type of wafer so that every integrated circuit on the wafer can be electrically tested.

The means for moving the chuck relative to the probe card may comprise an actuator for moving the chuck in three perpendicular directions and another actuator for rotating the chuck around the axis perpendicular to the chuck. The actuators are preferably arranged outside the first radiation shield or even outside the vacuum chamber so that the heat generated by the actuators does not heat the space in which the integrated circuits are tested, i.e. the interior of the first radiation shield. The actuator may comprise, for example, an electrical motor operating a screw, which transfers the rotational movement to linear movement. The moving means may comprise a supporting column having a first end and a second end. The first end of the supporting column can be attached to the chuck and the second end of the supporting column to the actuators. The movement produced by the actuators is thus transferred through the supporting column to the chuck. The supporting column can be made of a metal, such as stainless steel, or other material having good mechanical properties and a low thermal conductivity. The supporting column can be a one-piece or multi-piece tube that can be made of a sheet metal. The wall thickness of the tube can be in the range of 0.05 mm to 0.3 mm, which ensures that the heat transfer through the supporting column is minimal, while at the same time the supporting column is rigid enough to retain its shape.

The chuck and the probe card are arranged inside the first radiation shield. The first radiation shield acts as a thermal shield, reducing the heat transfer. In other words, the first radiation shield is a thermal radiation shield. The first radiation shield defines an essentially enclosed space into which the chuck and the probe card are placed. The first radiation shield may consist of one or more shield parts. The first radiation shield can be mechanically attached to but thermally isolated from the vacuum chamber or another radiation shield that encloses the first radiation shield. The first radiation shield can comprise a cylindrical side wall, an upper end wall attached about its perimeter to the upper edge of the side wall, and a lower end wall attached about its perimeter to the lower edge of the side wall. The first radiation shield can, for example, be made of aluminium.

Radiative heat transfer (emission/absorption) can be reduced by making surfaces of the first radiation shield and the inner surface of the vacuum chamber reflecting. The heat reflecting surface can be, for example, polished metal. The fraction of the heat reflecting surfaces can be maximized and only the non-idealities, such as gaps in the geometry are compensated by making the surfaces locally heat absorbing. The heat absorbing surface can be, for example, black anodized or painted in black.

The vacuum chamber allows the integrated circuits to be tested in a controlled environment. The conditions such as the pressure and temperature inside the vacuum chamber can be controlled using various devices. The testing device may comprise, for example, a vacuum pump connected to the vacuum chamber for controlling the pressure and a cooling unit connected to the vacuum chamber for controlling the temperature inside the vacuum chamber. The vacuum chamber can, for example, be made of stainless steel or aluminium. When testing the integrated circuits, the pressure inside the vacuum chamber is typically less than 10E-4 mbar.

The first window is hermetically attached to the wall, preferably an upper end wall, of the vacuum chamber. The first window covers an opening in the wall of the vacuum chamber and allows the vision system to see inside the vacuum chamber. The first window acts as a thermal filter and preferably only visible light (or the frequency range at which the camera is working) is transferred through the window.

The opening in the first radiation shield is arranged in the wall, preferably an upper end wall, of the first radiation shield. The shutter is arranged in connection with the opening and is movable between a closed position and an open position. In the closed position, the shutter closes the opening in the first radiation shield so that the radiation into the first radiation shield through the opening is blocked. In the open position, the vision system can see inside the first radiation shield through the first window in the vacuum chamber and the opening in the first radiation shield.

The vision system is positioned outside the vacuum chamber and aligned in line with the first window in the vacuum chamber and the opening in the first radiation shield in such a manner that the vision system can see inside the first radiation shield through the first window and the opening, when the shutter is open. The vision system may use pattern recognition techniques to locate the contact elements on the probe card and the contact pads on the wafer and using this information the vision system can determine the position of the wafer with respect to the probe card.

The vision system may comprise a camera for imaging the interior of the radiation shield through the first window in the vacuum chamber and the opening in the first radiation shield. The vision system may comprise a control unit connected to the camera for receiving the imaging data from the camera. The control unit comprises a processor and a memory including computer program code, the memory and the computer program code being configured to, with the processor, cause the control unit to determine, based on the imaging data, the position of the wafer with respect to the probe card. Using this position information, the moving means can be configured to move the chuck to a desired position with respect to the probe card.

The testing device may comprise an electronic testing unit for electrically testing the integrated circuits on the wafer. The electronic testing unit is electrically connected to the probe card. The probe card provides an electrical path between the electronic testing unit and the integrated circuits on the wafer, thereby permitting the testing and validation of the integrated circuits. The electronic testing unit tests the integrated circuits according to a test program, which defines the contents of test patterns and the sequence by which they are applied to the integrated circuits. The electronic testing unit may comprise a processor and a memory including computer program code, the memory and the computer program code being configured to, with the processor, cause the electronic testing unit to electrically test the integrated circuits.

An advantage of the testing device according to the invention is that the position of the wafer with respect to the probe card can be determined with a minimal temperature rise in the space in which the wafer is tested, i.e. inside the first radiation shield. Another advantage of the testing device according to the invention is that it enables to minimize the light exposure to the space in which the integrated circuits are tested. Still another advantage of the testing device according to the invention is that it enables to electrically test integrated circuits on a wafer at very low temperatures.

According to an embodiment of the invention the means for moving is configured to move the chuck relative to the probe card based on the determined position of the wafer with respect to the probe card. The moving means may comprise a control unit that is connected to the vision system to receive the position information from the vision system. Using this information, the control unit can control one or more actuators of the moving means to position the wafer to the testing position, in which the contact elements of the probe card are in electrical contact with the contact pads of the integrated circuits.

According to an embodiment of the invention the testing device comprises a second radiation shield arranged inside the vacuum chamber and enclosing the first radiation shield, the second radiation shield comprising a second window aligned in line with the first window and the opening. The second window acts as a thermal filter and preferably only visible light (or the frequency range at which the camera is working) is transferred through the window.

The first radiation shield is arranged inside the second radiation shield. The second radiation shield acts as a thermal shield, reducing the heat transfer. In other words, the second radiation shield is a thermal radiation shield. The second radiation shield defines an essentially enclosed space into which the first radiation shield is placed. The second radiation shield may consist of one or more shield parts. The second radiation shield can be mechanically attached to but thermally isolated from the vacuum chamber or another radiation shield that encloses the second radiation shield. The second radiation shield can comprise a cylindrical side wall, an upper end wall attached about its perimeter to the upper edge of the side wall, and a lower end wall attached about its perimeter to the lower edge of the side wall. The second radiation shield can, for example, be made of aluminium.

The second window is attached to the wall, preferably an upper end wall, of the second radiation shield. The second window covers an opening in the wall of the second radiation shield and allows the vision system to see inside the second radiation shield. The second window is aligned in line with the first window in the vacuum chamber and the opening in the first radiation shield in such a manner that the vision system can see inside the first radiation shield through the first window, the second window and the opening, when the shutter is open.

An advantage of the second radiation shield is that it further improves the heat shielding of the testing device, whereby the desired testing temperature inside the first radiation shield can be achieved and maintained with a less amount of energy compared to a testing device having only one radiation shield.

According to an embodiment of the invention the first radiation shield comprises a third window that covers the opening in the first radiation shield. The third window is attached to the wall of the first radiation shield. The third window acts as a thermal filter and preferably only visible light (or the frequency range at which the camera is working) is transferred through the window. An advantage of the third window is that it improves the heat shielding of the first radiation shield. The shutter can be replaced by the third window or preferably the third window is used together with the shutter.

According to an embodiment of the invention the window is made of fused silica. An advantage of fused silica is that it selectively transmits visible light through but effectively filters out thermal radiation.

According to an embodiment of the invention the diameter of the window and the opening is less than 70 mm. Preferably, the diameter of the window and the opening is in the range of 20 mm to 70 mm.

According to an embodiment of the invention the shutter comprises a plate arranged inside the first radiation shield and in connection with the opening, a shaft having a first end extending into the first radiation shield and attached to the plate and a second end extending out of the vacuum chamber, and an actuator attached to the second end of the shaft for rotating the shaft around its longitudinal axis. The shutter can be thermally anchored to the first radiation shield with a flexible thermal link, such as an aluminium or copper cable.

The plate is movable between a closed position and an open position. In the closed position, the plate closes the opening in the first radiation shield so that the radiation into the first radiation shield through the opening is blocked. In the open position, the vision system can see inside the first radiation shield through the window(s) and the opening. The plate is made of a thermally conducting material such as aluminium or copper. The shaft can consist of one or a plurality of successively arranged pieces. If the shaft is made of several pieces, the heat conduction through the shaft is very minimal. Preferably, the shaft or the shaft pieces are made of a material having a low thermal conductance. An example of a preferable material is glass fibre. In order to further decrease the heat conduction through the shaft, the shaft is preferably made hollow. The actuator is located outside of the vacuum chamber and arranged to move the plate between the closed and open positions. The actuator can be, for example, an electrical motor or a pneumatical cylinder with a lever.

According to an embodiment of the invention the vacuum chamber comprises a vacuum-tight lead-through through which the shaft is arranged to pass. The vacuum-tight lead-through is attached to the wall of the vacuum chamber.

According to an embodiment of the invention the radiation shield comprises a hole through which the shaft is arranged to pass, the hole being provided with a seal. The seal may comprise a first part attached to the shaft and a second part attached to the hole. The first part of the seal rotates with the shaft.

According to an embodiment of the invention the testing device comprises a cooling unit that is thermally connected to the first radiation shield and/or the second radiation shield. In this text, the expression "thermally connected" means that two members are connected such that heat can be conducted therebetween. The cooling unit is used for cooling the wafer to a desired testing temperature and for maintaining the testing temperature during testing of the integrated circuits. The testing temperature inside the first radiation shield can be, for example, in the range of 1-4 K. The heat is transferred out of the radiation shield through one or more thermal links connected between the cooling unit and the radiation shield. The thermal link can be, for example, a cable or bar made of copper or aluminium. Preferably, the cooling unit is thermally connected to both the first radiation shield and the second radiation shield. The cooling unit may comprise one or more temperature stages each of which is configured to provide a specific temperature to a radiation shield to which it is thermally connected. The cooling unit can be a closed loop circulation cooler based on Helium.

An advantage of the cooling unit is that it enables to electrically test integrated circuits on a wafer at very low temperatures, and even below 4 K.

According to an embodiment of the invention the cooling unit has a first temperature stage that is thermally connected to the first radiation shield and a second temperature stage that is thermally connected to the second radiation shield. The temperature stages of the cooling unit are configured to provide different temperatures to the radiation shields. The temperature that can be achieved with the first temperature stage is lower than the temperature that can be achieved with the second temperature stage. The temperature provided by the first temperature stage can be, for example, in the range of 3-5 K, or about 4 K, and the temperature provided by the second temperature stage can be, for example, in the range of 45-55 K, or about 50 K. The heat is transferred out of the first radiation shield through one or more thermal links connected between the first temperature stage and the first radiation shield. The heat is transferred out of the second radiation shield through one or more thermal links connected between the second temperature stage and the second radiation shield. The thermal link can be, for example, a cable or bar made of copper or aluminium.

An advantage of the cooling unit having two temperature stages is that the space in which integrated circuits are tested, i.e. the interior of the first radiation shield, can be more quickly and energy efficiently cooled to a desired testing temperature.

According to an embodiment of the invention the cooling unit has a third temperature stage that is thermally connected to the chuck and the probe card. Preferably, the third temperature stage is thermally connected to the probe card through a probe card holder. The temperature that can be achieved with the third temperature stage is lower than the temperature that can be achieved with the first temperature stage. The temperature provided by the third temperature stage can be, for example, in the range of 0.8-1.2 K, or about 1 K. The heat is transferred away from the chuck through one or more thermal links connected between the third temperature stage and the chuck. The heat is transferred away from the probe card through one or more thermal links connected between the third temperature stage and the probe card. The thermal link can be, for example, a cable or bar made of copper or aluminium.

As the chuck is cooled by the cooling unit, heat from the wafer that is mounted on the chuck may transfer to the chuck by conduction. Correspondingly, as the probe card is cooled by the cooling unit, heat from the wafer may transfer to the probe card when the probe card is in electrical contact with the integrated circuits. Heat is transferred by conduction through the contact pads of the integrated circuits and the contact elements of the probe card. The cooling unit thus enables to efficiently cool the wafer through the chuck and the probe card.

An advantage of cooling the chuck and the probe card using the third temperature stage of the cooling unit is that the space in which integrated circuits are tested, i.e. the interior of the first radiation shield, can be more quickly and energy efficiently cooled to a desired testing temperature. Another advantage of the testing device according to the invention is that it enables to electrically test integrated circuits on a wafer at very low temperatures, and even below 4 K.

According to an embodiment of the invention the cooling unit is a dry cryostat using a closed loop helium circulation. When the dry cryostat is used, the vacuum chamber is kept at room temperature (not in a liquid nitrogen or liquid helium bath) and all the low temperature components are located inside the vacuum chamber. The dry cryostat may comprise a plurality of temperature stages, for example, 50 K, 4 K and 1 K stages. An advantage of the dry cryostat is that the space in which integrated circuits are tested, i.e. the interior of the first radiation shield, can be cooled to a temperature below 4 K without immersing the whole system into a liquid helium bath.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

### BRIEF DESCRIPTION OF THE DRAWINGS

- Fig. 1: illustrates a sectional view of a testing device according to an embodiment of the invention, and
- fig. 2: illustrates an exemplary shutter.

### DETAILED DESCRIPTION OF THE DRAWINGS

The same reference signs are used of the same or like components in different embodiments.

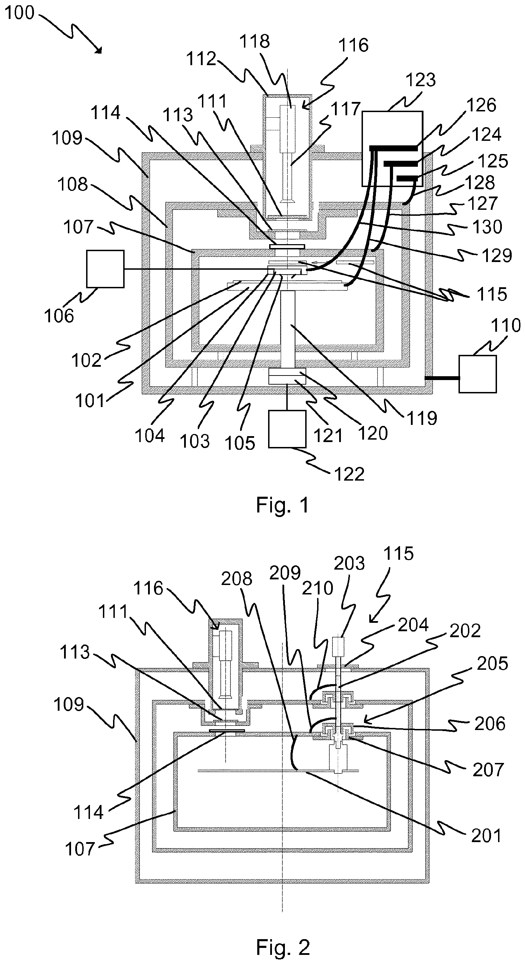

Fig. 1 illustrates a sectional view of a testing device according to an embodiment of the invention. The testing device 100 comprises a chuck 101 for holding a wafer 102 that comprises integrated circuits, and a probe card 103 attached to a probe card holder 104 for electrically contacting the integrated circuits on the wafer 102. The probe card 103 comprises contact elements 105, which can be arranged in electrical contact with contact pads of the integrated circuits. The electrical testing of the integrated circuits is done with an electronic testing unit 106 that is electrically connected to the probe card 103. The probe card 103 provides an electrical path between the electronic testing unit 106 and the integrated circuits on the wafer 102.

The testing device 100 comprises two nested radiation shields 107 and 108, which are arranged inside a vacuum chamber 109. The chuck 101 and the probe card 103 are arranged inside the innermost radiation shield 107. The vacuum chamber 109 allows the integrated circuits to be tested in a controlled environment. The pressure inside the vacuum chamber 109 is controlled with a vacuum pump 110.

The vacuum chamber 109 comprises a window 111 that is attached to the wall of the vacuum chamber 109. The window 111 covers an opening in a housing 112 that forms part of the vacuum chamber 109. The radiation shield 108 comprises a window 113 that is attached to the wall of the radiation shield 108 to cover an opening in the radiation shield wall.

The radiation shield 107 comprises a window 114 that is attached to the wall of the radiation shield 107 to cover an opening in the radiation shield wall. The window 114 is arranged in line the windows 111 and 113. The opening that is covered by the window 114 is provided with a shutter 115 for closing the opening. The shutter 115 is movable between a closed position and an open position. In the closed position, the shutter 115 closes the opening in the radiation shield 107 so that the radiation into the radiation shield 107 through the opening is blocked. In the open position, a vision system 116 can see inside the radiation shield 107 through the windows 111, 113 and 114.

The vision system 116 comprises a camera 117 for imaging the interior of the radiation shield 107 through the windows 111, 113 and 114. The camera 117 is positioned inside the housing 112. The vision system 116 comprises a control unit 118 that is connected to the camera 117 for receiving the imaging data from the camera 117. The control unit 118 determines, based on the imaging data, the position of the wafer 102 with respect to the probe card 103. Using this position information, the chuck 101 can be moved to a desired position with respect to the probe card 103.

The chuck 101 can be moved relative to the probe card 103 with moving means that comprise a supporting column 119 having a first end and a second end. The first end of the supporting column 119 is attached to the chuck 101 so that the chuck 101 is perpendicular with respect to the longitudinal axis of the supporting column 119. The moving means also comprise an actuator 120 for moving the supporting column 119 in three perpendicular directions, and an actuator 121 for rotating the supporting column 119 around its longitudinal axis. The actuators 120 and 121 are attached to the second end of the supporting column 119 so that the movement is transferred through the supporting column 119 to the chuck 101. The supporting column 119 is arranged to pass through the walls of the radiation shields 107 and 108 so that the first end of the supporting column 119 extends into the interior of the radiation shield 107, and the second end of the supporting column 119 extends out of the radiation shield 108.

The moving means comprise a control unit 122 that is connected to the control unit 118 to receive the position information from the vision system 116. Using this information, the control unit 122 controls the actuators 120 and 121 to position the wafer 102 to a testing position, in which the contact elements 105 of the probe card 103 are in electrical contact with the contact pads of the integrated circuits.

The testing device 100 comprises a cooling unit 123 for cooling the wafer 102 to a desired testing temperature and for maintaining the testing temperature during testing of the integrated circuits. The cooling unit comprises three temperature stages 124, 125 and 126, each of which is configured to provide a specific temperature to a part to which it is thermally connected. The first temperature stage 124 is thermally connected to the radiation shield 107 and the second temperature stage 125 is thermally connected to the radiation shield 108. The temperature that can be achieved with the first temperature stage 124 is lower than the temperature that can be achieved with the second temperature stage 125. The heat is transferred out of the radiation shield 107 through a thermal link 127 connected between the first temperature stage 124 and the radiation shield 107. The heat is transferred out of the radiation shield 108 through a thermal link 128 connected between the second temperature stage 125 and the radiation shield 108. The third temperature stage 126 is thermally connected to the chuck 101 and the probe card 103. The temperature that can be achieved with the third temperature stage 126 is lower than the temperature that can be achieved with the first temperature stage 124. The heat is transferred away from the chuck 101 through a thermal link 129 connected between the third temperature stage 126 and the chuck 101. The heat is transferred away from the probe card 103 through a thermal link 130 connected between the third temperature stage 126 and the probe card 103.

Fig. 2 illustrates an exemplary shutter. The shutter 115 comprises a plate 201 that is arranged inside the radiation shield 107 and in connection with the opening covered by the window 114. The shutter 115 comprises a shaft 202 having a first end extending into the radiation shield 107 and attached to the plate 201 and a second end extending out of the vacuum chamber 109. The shutter 115 comprises an actuator 203 that is attached to the second end of the shaft 202 for rotating the shaft 202 around its longitudinal axis.

The plate 201 can be moved with the actuator 203 between a closed position and an open position. In the closed position, the plate 201 closes the opening that is covered by the window 114 so that the radiation into the radiation shield 107 through the opening is blocked. In the open position, the vision system 116 can see inside the radiation shield 107 through the windows 111, 113 and 114.

The vacuum chamber 109 comprises a vacuum-tight lead-through 204 through which the shaft 202 is arranged to pass. The vacuum-tight lead-through 204 is attached to the wall of the vacuum chamber 109. Each radiation shield 107 and 108 comprises a hole through which the shaft 202 is arranged to pass. The hole is provided with a seal 205 that comprises a first part 206 attached to the shaft 202 and a second part 207 attached to the radiation shield 107, 108. The first part 206 of the seal 205 rotates with the shaft 202.

The plate 201 is thermally connected to the radiation shield 107 with a thermal link 208. The shaft 202 is thermally connected to the radiation shields 107 and 108 with thermal links 209 and 210, respectively.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A testing device, comprising:
- a vacuum chamber,
- a chuck for holding a wafer that comprises integrated circuits,
- a probe card for electrically contacting the integrated circuits on the wafer,
- a first radiation shield arranged inside the vacuum chamber and enclosing the chuck and the probe card, and
- means for moving the chuck relative to the probe card,
**characterised in that**:
- the vacuum chamber comprises a first window,
- the first radiation shield comprises an opening provided with a shutter for closing the opening, and
- the testing device comprises a vision system positioned outside the vacuum chamber and aligned in line with the first window and the opening, the vision system being configured to determine the position of the wafer with respect to the probe card.

2. The testing device according to claim 1, **characterised in that** the means for moving is configured to move the chuck relative to the probe card based on the determined position of the wafer with respect to the probe card.

3. The testing device according to claim 1 or 2, **characterised in that** the testing device comprises a second radiation shield arranged inside the vacuum chamber and enclosing the first radiation shield, the second radiation shield comprising a second window aligned in line with the first window and the opening.

4. The testing device according to any of the preceding claims, **characterised in that** the first radiation shield comprises a third window that covers the opening in the first radiation shield.

5. The testing device according to any of the preceding claims, **characterised in that** the window is made of fused silica.

6. The testing device according to any of the preceding claims, **characterised in that** the diameter of the window and the opening is less than 70 mm.

7. The testing device according to any of the preceding claims, **characterised in that** the shutter comprises a plate arranged inside the first radiation shield and in connection with the opening, a shaft having a first end extending into the first radiation shield and attached to the plate and a second end extending out of the vacuum chamber, and an actuator attached to the second end of the shaft for rotating the shaft around its longitudinal axis.

8. The testing device according to claim 7, **characterised in that** the vacuum chamber comprises a vacuum-tight lead-through through which the shaft is arranged to pass.

9. The testing device according to claim 7 or 8, **characterised in that** the radiation shield comprises a hole through which the shaft is arranged to pass, the hole being provided with a seal.

10. The testing device according to any of the preceding claims, **characterised in that** the testing device comprises a cooling unit that is thermally connected to the first radiation shield and/or the second radiation shield.

11. The testing device according to claim 10, **characterised in that** the cooling unit has a first temperature stage that is thermally connected to the first radiation shield and a second temperature stage that is thermally connected to the second radiation shield.

12. The testing device according to claim 11, **characterised in that** the cooling unit has a third temperature stage that is thermally connected to the chuck and the probe card.

13. The testing device according to any of claims 10 to 12, **characterised in that** the cooling unit is a dry cryostat using a closed loop helium circulation.
